Europäisches Patentamt

European Patent Office

Office européen des brevets

(11) Publication number: **0 173 060**
**A2**

(12) # EUROPEAN PATENT APPLICATION

(21) Application number: **85108960.7**

(22) Date of filing: **17.07.85**

(51) Int. Cl.⁴: **G 11 C 11/24**

(30) Priority: **24.07.84 IT 8339084**

(43) Date of publication of application: **05.03.86**
**Bulletin 86/10**

(84) Designated Contracting States: **AT BE CH DE FR GB IT LI LU NL SE**

(71) Applicant: **ZELTRON ISTITUTO ZANUSSI PER L'ELETTRONICA S.P.A., Via Principe di Udine, 66, I-33030 Campoformido Udine (IT)**

(72) Inventor: **Nadalutti, Gianfranco, Via della Chiesa 21, I-33040 Moimacco (Udine) (IT)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(54) **Method for controlling memory components and memory circuit board controlled by this method.**

(57) A method for controlling memory components of 16K × 1 bit or 64K × 1 bit by employing a control bus adapted to components of 4K × 1 bit, wherein a memory refresh signal (REF) is generated indpendent of the one supplied by the system.

A memory circuit board, particularly, but not exclusively, a memory circuit board for a system for inspecting or testing electronic components, having a capacity of 32K or 64K words of 24 data bits and one parity bit, and including a refresh signal generating block (REFRESH TIMING) operating according to the method defined above.

# 1 Description

The present invention relates to a method for controlling memory components. In particular, the present invention relates to a method for controlling memory components of 16K x 1 bit or 64K x 1 bit by the use of a data bus and a control bus adapted for components of 4K x 1 bit.

The invention further relates to a memory circuit board making use of this method. A circuit board of this type is particularly, although not exclusively, intended for installation in a device for the inspection and testing of electronic components. Apparatus for the inspection and testing of electronic components is manufactured for instance by the Fairchild Co. (USA) and marketed under the designation Sentinel, Sentry VII, Sentry VIII etc..

The circuit boards according to the invention may be installed as original parts or as replacement for the original circuit boards installed in such apparatus. The present invention offers the advantage of being capable of replacing four conventional circuit boards equipped with components of 16K x 1 bit, or eight conventional circuit boards equipped with components of 64K x 1 bit.

Conventional memory circuit boards are normally used in two groups each containing at least one circuit board up to a maximum of twelve circuit boards. Each of these circuit boards has a storage capacity of 8K words. They are in the form of printed circuits of the read-and-write memory type (RAM) with a capacity of 8K words of 24 data bits and 1 parity bit.

The method according to the invention permits the functionality of the conventional circuit boards to be obtained while reducing the number of components to a quarter or to one-eightth in the case of printed circuits of 32K words, or 64K words, respectively. The reduction of the number of components employed on a circuit board according to the invention results in increased reliability of the memory

0173060

system of the apparatus, with the consequent reduction of failure probability.

It is thus an object of the invention to provide a circuit board of the type defined above, which is capable, depending on the installation configuration, to replace one to eight circuit boards of the conventional type without requiring any modification of the hardware of the apparatus.

In the following, the memory circuit board according to the invention shall be considered as a unitary entity irrespective of whether it is equipped with 16 K components or with 64K components. As a matter of fact, the circuitry of the circuit board permits the memory components to be interchangeable while remaining itself unchanged, so as to selectively provide an overall storage capacity of 32K words or 64K words, depending on the memory components employed.

For the control of components of 32K or 64K, the invention provides the employ of a known data bus and a known control bus adapted to components of 4K. The method according to the invention provides the employ of:

a) a data bus for dynamic memories of 4K for addressing and exchanging data with a bus formed with memories of 16K or 64K;

b) a control bus for circuit boards of 8K for the control of circuit boards of 32K or 64K.

The function defined under a), above, is obtained by employing particular temporary storage components (latch) associated with the data bus. These components permit to circumvent the fact that the memories of 16K or 64K do not retain the data in the buffer for a sufficient time for being acquired by the processor of the apparatus.

The function defined under b), above, is obtained by the application of a novel operating logic which permits the selection of the circuit board carrying a suitable circuit thereon, and additionally the generation of memory refresh

addresses independent of those supplied by the processor of the apparatus.

The present invention is thus embodied in a method for controlling memory components of 16K x 1 bit or 64K x 1 bit by using a control bus adapted to components of 4K x 1 bit, which is characterized in that a memory refresh signal is generated which is independent of the one supplied by the system.

On the other hand, the present invention is embodied in a memory circuit, particularly, but not exclusively, in a memory circuit board for an electronic component inspection or testing system, said circuit board having a capacity of 32K or 64K words of 24 data bit and 1 parity bit, said circuit board further having two memory blocks, two address buffer blocks, one line access signal decoder block, one line or column address selection block, one refresh address generator block, one input data acquisition block, one line address acquisition block, one column address acquisition block, one bank selection block, and one enter signal control block, said memory circuit board being characterized by further comprising a refresh signal generator block, a block for the acquisition of data provenient from the memory components, a control signal processing block, and a circuit board selection block, said refresh signal generator block operating in accordance with the method defined above.

Embodiments of the invention shall now be described by way of non-limiting example with referece to the accompanying drawings, wherein:

fig. 1 shows an overall block diagram of a circuit board according to the invention,
fig.2a shows a diagram of a stored data refresh block,
fig.2b shows the operation of this block,
fig. 3a and 3b show in particular the transfer of a datum from a memory component to the bus of the system,
fig. 4 shows the manner in which the circuit board selection signal is generated, and
figs. 5, 6 and 7 show the read cycle, the write cycle, and
the memory refresh cycle, respectively.

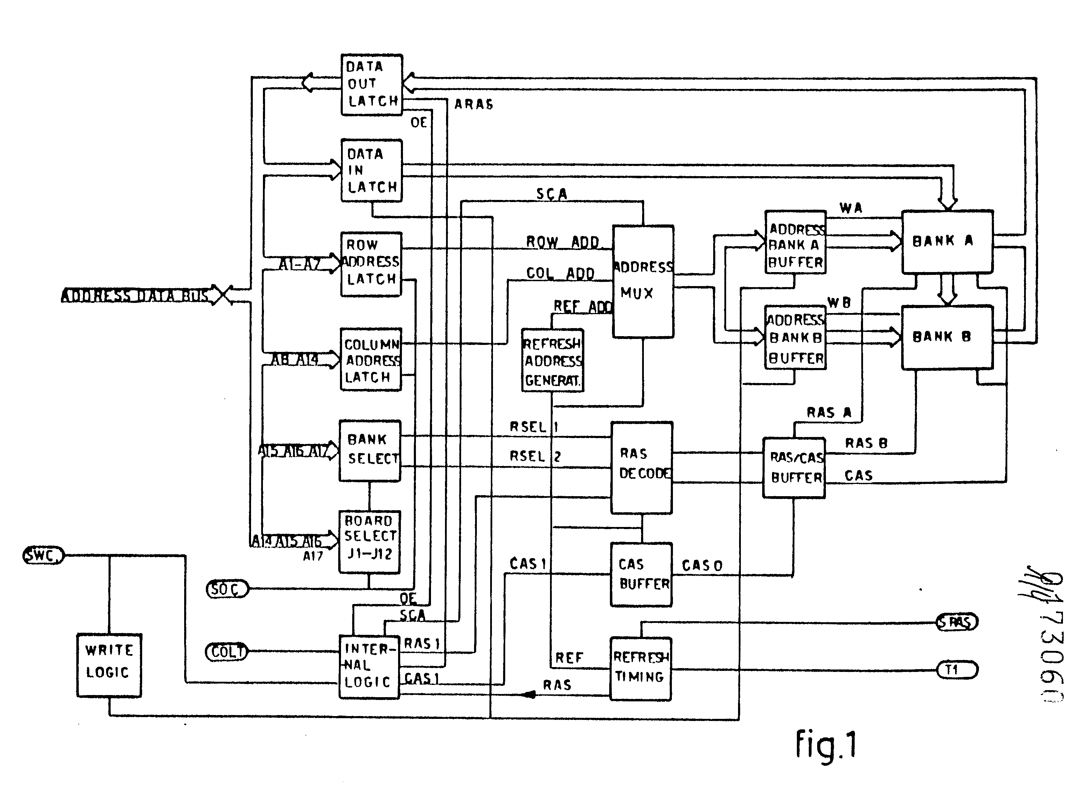

Shown in fig. 1 are the functional blocks constituting a
circuit board according to the invention, including two
memory blocks designated BANK A and BANK B, respectively.
These blocks form the central nucleus of the circuit to
which the function is assigned of storing the data supplied
to the memory by the central processing unit CPU.

These memory blocks together comprise 50 components of
16K x 1 bit or 25 components of 64K x 1 bit, depending on
whether the circuit has a capacity of 32K or 64K
words. These components are advantageously in the form of
dynamic RAMs realized for instance in the single feed
H-MOS technology. The data are supplied to the two memory
banks through the acquisition block DATA IN LATCH. The
data may be retrieved from these banks as required through
the acquisition block DATA OUT LATCH for supply to the
bus of the CPU. The ROW ADDRESS LATCH and COLUMN ADDRESS
LATCH blocks acquire the row and column addresses, respectively for selecting the memory location from which a datum
is to be read or into which it is to be written.

The row addresses, column addresses and refresh addresses
are supplied during different phases to the memory banks A
and B through the ADDRESS MUX block.

The BANK SELECT block decodes the three most significant
addresses for selecting the memory bank in which or from
which, respectively, the data are to be stored or retrieved.

The RAS DECODE block opens the passage to the RAS signal
(row address selection signal) and applies it to the two
memory banks during the refresh phase, or to the active
babk during the read or write phase.

The blocks RAS/CAS BUFFER and CAS BUFFER impose on the
RAS and CAS signals characteristics enabling them to con-

temporaneously control all of the installed memory components.

The BOARD SELECT block decodes the four most significant addresses on the base of which the memory circuit is selected by the CPU.

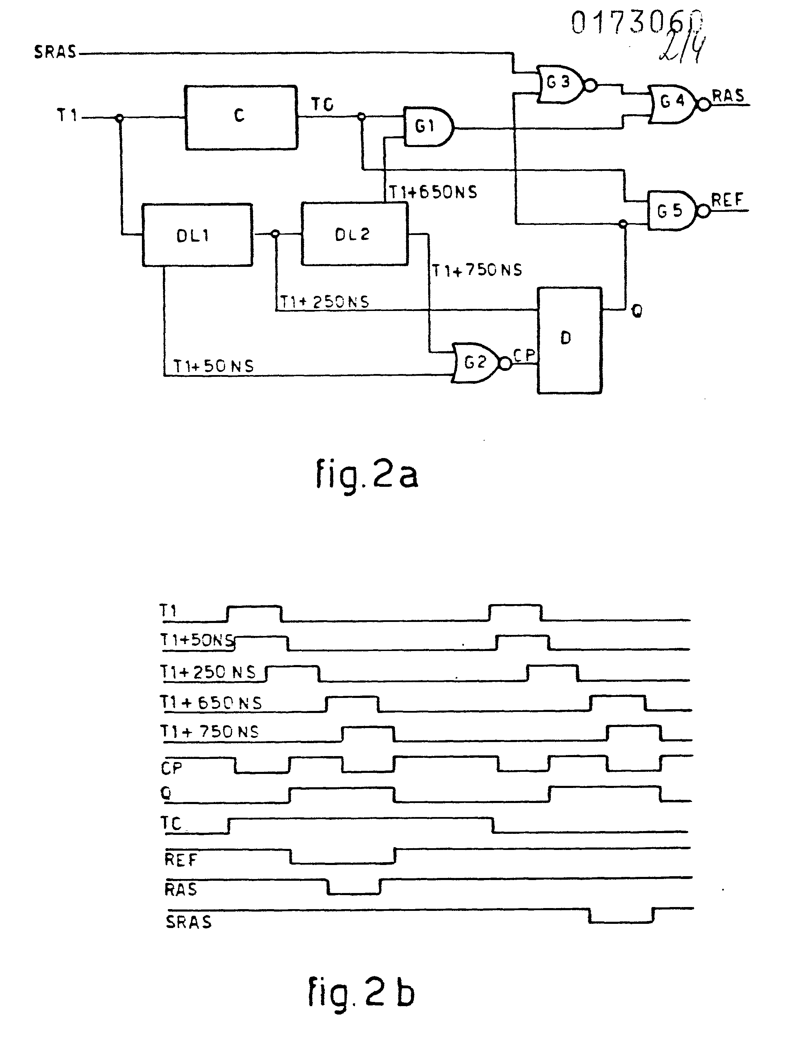

The REFRESH TIMING and REFRESH ADDRESS GENERATOR blocks generate the refresh addresses and apply them to the memory components in synchronism with the phase T1 (cf. figs. 2a and 2b) of the system, and independent of the refresh signal supplied by the CPU.

The INTERNAL LOGIC block regulates the signals supplied by the control bus and cooperates with the WRITE LOGIC block for selecting the transit direction of the data.

Fig. 2a shows in greater detail the interrelation between the INTERNAL LOGIC and REFRESH TIMING blocks.

Shown therein is the signal REF for incrementing the refresh address counter..This signal, which is fundamental for the operation of the circuit boards according to the invention, is generated in the following manner:

The signal T1 supplied in the example shown by the CPU is retarded respectively by 50 ns; 250 ns; 650 ns; and 750 ns by delay elements DL1 and DL2. The delays by 50, 250, 650 and 750 ns are merely indicative as they may vary by as much as 50% in each case. The delay indicated at 50 ns may thus vary between 30 and 80 ns, the delay indicaetd at 750 ns may vary between 700 and 820 ns, the delay indicated at 250 ns may vary between 150 and 350 ns, and the delay indicated at 650 ns may vary between 500 and 700 ns. In the present example, only four delay values are shown, it is also possible, however, to employ a number of different values including multiplicators and/or combinators. With the delays indicated there are thus obtaiend four signals, which through combination by means of the logic gate G2 and flip-flop D generate the signal Q. During the period of time in which TC is at a high level this signal is converted by the logic gate G5 into the signal REF, i.e. the memory component refresh signal. The signal TC rises from the low level to the high level every eight   pulse T1. As in the present example the repetition period of T1 equals 1,75 µs, REF is accordingly activated every 8 x 1,75 µs. And as there are 128 row addresses to be refreshed, each row is activated every 179 µs, as is necessary for the correct functioning of the employed memory components.

In prior art the signal REF is supplied by the CPU every 26,25 µs, and is adapted to refresh memory components having a structure of 64 rows by 64 columns (4K). A refresh signal obtained according to the invention permits the employ of memory components of 16K x 1 bit or 64K x 1 bit. As a result, a circuit board according to the invention can replace four to eight prior art circuit boards.

As regards the row address acquisition signal RAS, it is shown in fig. 2a how this signal is generated, during the refresh cycle, by the gate G1 by combining TC with T1+650ns. In addition, and still during the refresh phase, the gate G3 obstructs the row acquisition signal SRAS supplied by the CPU.

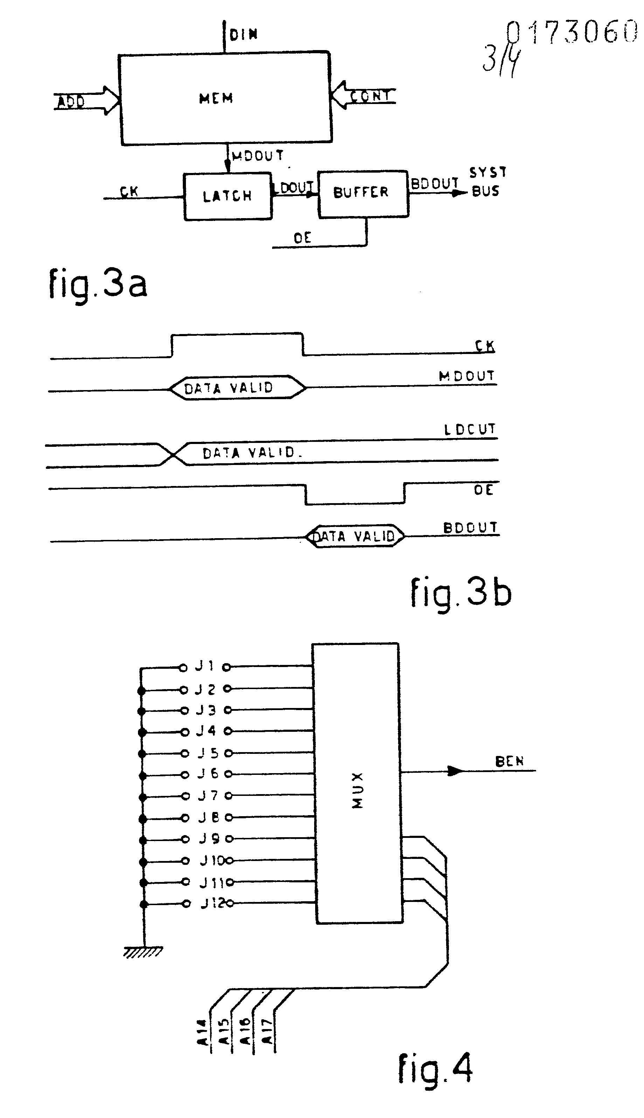

Fig. 3a shows the manner in which, according to the invention, a datum from one memory component MEM is transferred to the system bus SYST BUS (read phase). Observing the timing as represented in fig. 3b, it is noted that the datum MDOUT retrieved from the memory component MEM is transferred to the system bus via the components LATCH and BUFFER when the said datum is no longer valid at the output of the memory component. In prior art arrangements employing components of 4K the component LATCH is internal of the memory component.

Shown in fig. 4 is the manner in which, according to the invention, the board selection signal BEN is obtained. This figure shows a multiplexer component MUX and a series of

0173060

twelve bridges (J1 - J12). The component MUX decodes the most significant addresses (A14 - A27), associating a respective bridge to each possible configuration thereof. Depending on wether the bridge is or is not installed, the signal BEN assumes at least the logic state zero and becomes the board selection signal. In prior art the selection of a circuit board is conversely accomplished by suitable connections, external of the circuit board, and only adapted to circuit boards carrying memory components of 4K.

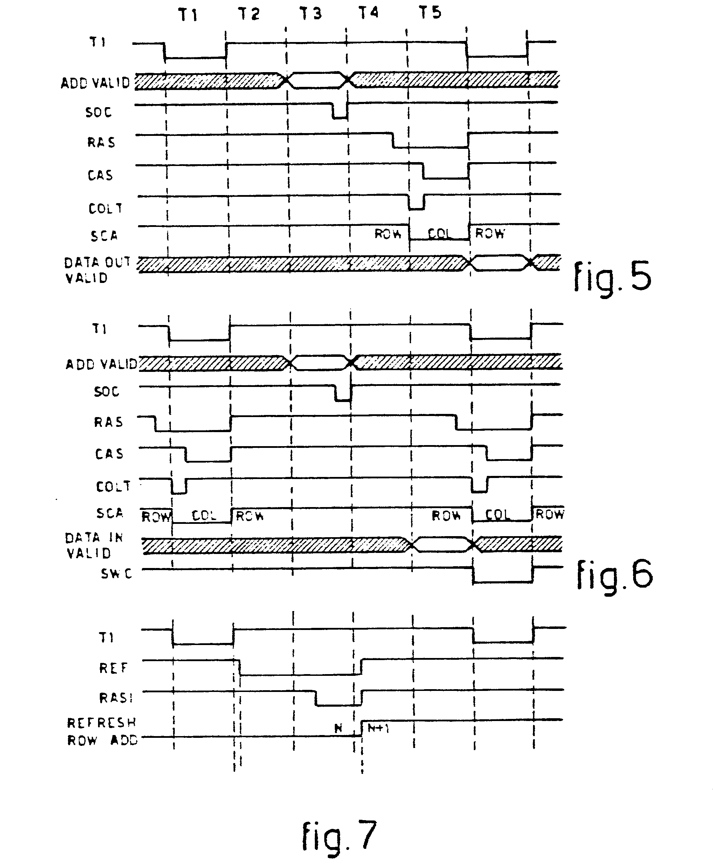

Figs. 5, 6 and 7 show the timing sequences of the various signals. In particular, fig. 5 shows the read cycle, fig. 6 shows the write cycle, and fig. 7 illustrates the refresh cycle.

0173060

LEGEND

| | |
|---|---|
| BANK A | Memory block A |
| BANK B | memory block B |
| MEM | memory component |
| ADDRESS BANK A BUFFER | address buffer of bank A |
| ADDRESS BANK B BUFFER | address buffer of bank B |
| RAS/CAS BUFFER | buffer for signals RAS and CAS |
| RAS DECODE | selection block for read/write or refresh RAS signal |
| ADDRESS MUX | commutator block for row, column and refresh addresses |
| REFRESH TIMING | block generating REF signal |
| REFRESH ADDRESS GENERATOR | counter generating refresh addresses |
| WRITE LOGIC | block for memory writ signal SWC |
| INTERNAL LOGIC | block controlling control signals |
| BOARD SELECT | board selection block |
| BANK SELECT | memory bank selection block |
| COLUMN ADDRESS LATCH | column address acquisition block |
| ROW ADDRESS LATCH | row address selection block |
| DATA IN LATCH | input data acquisition block |
| DATA OUT LATCH | block for acquisition of data from memory components |
| ADDRESS DATA BUS | system bus |
| A1 - A17 | addresses from A1 to A17 |
| SOC | address acquisition start signal |
| COLT | row or column address selection signal |
| RAS | row access signal |
| SRAS | row access signal from system |
| CAS | column access signal |
| SWC | input data storage enable signal |
| REF | memory refresh enable signal |
| T1 | synchron signal |

0173060

| | |
|---|---|
| SCA | column address selestion |
| WA | write enable bank A |
| WB | write enable bank B |
| RSEL 1 | row selection |
| RSEL 2 | row selection |
| OE | data output enable |
| C | counter |
| DL1 | retard block |
| DL2 | retard block |
| D | flip-flop |
| G1 | logic gate |
| G2 | logic gate |
| G3 | logic gate |
| G4 | logic gate |
| G5 | logic gate |
| TC | counter output signal |
| CP | signal gate G2 |
| Q | refresh origin signal |
| CK | clock signal |
| DIN | data input |
| MD OUT | data output from memory components |
| LD OUT | data output latch |
| BD OUT | data output buffer |
| ADD | addresses |
| CONT | controls |
| DATA VALID | data validity period |
| ADD VALID | address validity period |
| J1 - J12 | bridges |
| BEN | board selection signal |

PATENTANWÄLTE 0173060

A GRÜNECKER
DR H KINKELDEY
DR W STOCKMAIR
DR K SCHUMANN
P H JAKOB
DR G BEZOLD
W MEISTER
H HILGERS
DR H MEYER PLATH
DR M BOTT-BODENHAUSEN
DR U KINKELDEY

EUGEN D EN DROIT DE LYON DE GENÈVE

8000 MÜNCHEN 22
MAXIMILIANSTRASSE 58

EP 2407-505

Method for Controlling Memory Components and Memory Circuit Board Controlled by this Method

Patent Claims:

1.    A method for controlling memory components of 16K x 1 bit or 64K x 1 bit by using a control bus adapted to components of 4K x 1 bit, characterized in that there is generated a memory refresh signal (REF) independent of the one supplied by the system.

2.    A method according to claim 1, characterized in that said memory refresh signal (REF) is obtained by assigning at least one delay to the synchron signal (T1) supplied by the system.

3.    A method according to claim 1 or 2, characterized in that at least one delay is comprised between 30 and 80ns.

4.      A method according to any of claims 1 to 3, characterized in that at least one delay is comprised between
150 and 350 ns.

5.      A method according to any of claims 1 to 4, characterized in that at least one delay is comprised between
500 and 700 ns.

6.      A method according to any of claims 1 to 5, characterized in that at least one delay is comprised between
700 and 800 ns.

7.      A method according to any of the preceding claims,
characterized in that two signals having different delays
(for example T1 + 50 ns, T1 + 750 ns) are combined in a
logic gate (G2), the signal (CP) thus obtained is applied
to a flip-flop (D) together with a further delayed signal
(for example T1 + 250 ns), and the signal (Q) thus obtained
is combined with a signal (TC) provenient from a counter (C)
in a logic gate (G5), whereby to obtain the refresh
signal (REF).

8.      A method according to any of the preceding claims,
characterized in that a retarded signal (for example
T1 + 650 ns) is combined with the signal (TC) provenient
from the counter (C) in a logic gate, and is finally
processed in a second logic gate (G4) for generating the
row access signal (RAS).

9.      A method according to any of the prece-ding claims,
characterized in that the row access signal (SRAS) supplied
by the system is suppressed, at least during the refresh
cycle, by logic gates (G3, G4).

10.      A method according to any of the prece-ding claims,
characterized in that the data retrieved from the memory
components are acquisitioned in transitory storage components (LATCH) prior to being transferred to the bus of the
system.

0173060

11. Memory circuit board, particularly but not exclusively a memory circuit board for a system for inspecting or testing electronic components, having a capacity of 32K or 64K words of 24 data bits and one parity bit and including two memory blocks (BANK A, BANK B), two address buffer blocks (ADDRESS BANK A BUFFER and ADDRESS BANK B BUFFER), a row access signal decoder block (RAS DECODE), a row or column address selection block (ADDRESS MUX), a refresh address generator block (REFRESH ADDRESS GENERATOR), an input data acquisition block (DATA IN LATCH), a row address acquisition block (ROW ADDRESS LATCH), a column address acquisition block (COLUMN ADDRESS LATCH), a bank selection block (BANK SELECT), and a write signal control block (WRITE LOGIC), characterized by:
- a refresh signal generator block (REFRESH TIMING),
- a block for the acquisition of data provenient from the memory components (DATA OUT LATCH),
- a control signal control block (INTERNAL LOGIC), and
- a board selection block (BOARD SELECT),
said refresh signal generator block (REFRESH TIMING) operating in accordance with the method as claimed in any of claism 1 to 10.

12. A memory circuit board according to claim 11, characterized in that said board selection block (BOARD SELECT) generates a signal for the selection of a board as a function of bridges (J1 - J12) installed on the board itself.

13. A memory circuit board according to claims 11 and 12, characterized in that it employs memory components of 64K x 1 bit.

14. A memory circuit board according to claim 11 and 12, characterized in that it employs memory components of 16K x 1 bit.

fig.1

fig.2a

fig.2b

fig.3a

fig.3b

fig.4

fig.5

fig.6

fig.7